# EUROPEAN PATENT APPLICATION

(11) **EP 4 572 544 A1**
(43) Date of publication of application: **18.06.2025**
(21) Application number: 23852836.8
(22) Date of filing: 31.07.2023
(51) Int. Cl.: H05K 5/02, B60R 16/023, H01R 13/652, H01R 13/621

(54) **BRACKET, ELECTRONIC DEVICE, AND AUTOMOTIVE VEHICLE**

(30) Priority: 12.08.2022 KR 20220101624; 12.08.2022 KR 20220101625
(71) Applicant: LG INNOTEK CO. LTD, Gangseo-gu Seoul 07796 (KR)
(72) Inventor: HWANG, Ga Hee, Seoul 07796 (KR); SONG, Kun Yong, Seoul 07796 (KR)
(74) Representative: DREISS Patentanwälte PartG mbB
(86) International application number: PCT/KR2023/011166
(87) International publication number: WO 2024/034955

(57) **Abstract**

A bracket comprising: a base, and a first support part having a shape protruding upwardly with respect to the base, wherein the base comprises a first hole penetrating from the upper surface to the bottom surface thereof, and the first support part is connected to the inner perimeter of the first hole.

## Description

### [Technical Field]

The teachings in accordance with exemplary and non-limiting embodiments of the present invention relate generally to a bracket, an electronic device and an automotive vehicle.

### [Background Arts]

The electronic devices in a vehicle are generally the engine electrical system (starter, ignition, charging device) and the lighting system, but recently, as vehicles have become more electronically controlled, most systems, including the chassis electrical system, are becoming more electrically and electronically controlled.

The various electronic devices installed in vehicles, such as lamps, audio, heaters, and air conditioners, are powered by the battery when the car is stopped and by the generator when the car is in motion. At this time, the power generation capacity of the 14V system is used as the normal power supply voltage.

In recent years, with the development of the information technology industry, various new technologies (motor-driven power steering, internet, etc.) have been incorporated into vehicles to increase the convenience of automobiles, and it is expected that the development of new technologies that can make the most of the current automotive system will continue in the future.

A vehicle is equipped with multiple electronic devices. A plurality of (Multiple) electronic devices is combined with each other through a bracket. The bracket includes a plurality plates corresponding to the direction of coupling of each of the multiple electronic devices. For example, the bracket may include a first plate that is coupled to the first electronic device and a second plate that is coupled to the second electronic device. In this case, the first and second plates can be joined to each other by welding.

According to the above-mentioned structure, different plates need to be joined together according to the layout area and number of electronic devices, which causes a problem of decreased production efficiency as the number of parts and assembly man-hours increase.

### [Detailed Description of the Invention]

### [Technical Problems]

The present exemplary embodiment provides a bracket and an electronic device that can improve the structure to reduce the manufacturing cost by reducing the number of parts and improve production efficiency.

The present exemplary embodiment also provides an electronic device that enables a simpler grounding structure in the electrical connection area.

### [Technical Solution]

In one general aspect of the present invention, there may be provided a bracket, comprising: a base, and a first support part having a shape protruding upwardly with respect to the base, wherein the base comprises a first hole penetrating from an upper surface to a bottom surface thereof, and the first support part is connected to an inner perimeter of the first hole.

Preferably, but not necessarily, a cross-sectional shape of the first support part may correspond to a cross-sectional shape of the first hole.

Preferably, but not necessarily, the base and the first support part may be formed as one body.

Preferably, but not necessarily, the first support part may include a first side surface facing the first hole and a second side surface opposite to the first side surface, and may include a support coupling part wherein one end is in contact with the base and the other end is in contact with the first support part.

Preferably, but not necessarily, the base may include a second hole in which an inner perimeter is connected to one end of the support coupling part, and a cross-sectional shape of the second hole may correspond to a cross-sectional shape of the support coupling part.

Preferably, but not necessarily, the support coupling part may be welded to one side of the first support part.

Preferably, but not necessarily, the support coupling part may be welded to an upper surface of the base.

Preferably, but not necessarily, the support coupling part may be provided in multiple numbers, and the base may be formed with a plurality of holes each having a shape corresponding to the cross-sectional shape of the multiple support coupling parts.

Preferably, but not necessarily, the support coupling part may be bent at least once and may include multiple regions that are positioned perpendicularly to each other.

In another general aspect of the present invention, there may be provided with an electronic device, the device, comprising: a bracket; a first module disposed on one surface of the bracket; and a second module disposed on the other surface of the bracket, wherein the bracket includes a base disposed between the first module and the second module; and a first support part having a shape that protrudes upward with respect to the base and supporting a side of the second module, wherein the base includes a first hole penetrating a lower surface from an upper surface, and the first support part is connected to an inner perimeter of the first hole.

### [Advantageous Effects]

Through the present exemplary embodiments, a coupled area of multiple modules is formed through a single metal plate, which has the advantage of reducing the number of parts for forming the bracket, thereby lowering the manufacturing cost, and improving production efficiency by omitting the joining process between multiple plates.

In addition, the grounding terminal is integrally formed in the plastic housing, which has the advantage of making the connector module's grounding structure lighter and simpler.

Furthermore, the grounding structure that is connected with the assembly of the housing and the connector module has the advantage of improving assembly and production efficiency.

### [Brief Description of Drawings]

FIG. 1 is a plan view showing the side of an electronic device according to the first exemplary embodiment of the present invention.
FIG. 2 is a top view of the bracket according to the first exemplary embodiment of the present invention.
FIG. 3 is a side view of a bottom of the bracket according to the first exemplary embodiment of the present invention.
FIG. 4 is a top view of the bracket according to the second exemplary embodiment of the present invention.
FIG. 5 shows a top view of the bracket according to the third exemplary embodiment of the present invention.
FIG. 6 is a magnified view of a portion of FIG. 5.
FIG. 7 is a perspective view of the exterior of an electronic device according to a fourth exemplary embodiment of the present invention.
FIG. 8 is a drawing in which a housing and a cover are disassembled from FIG. 7.
FIG. 9 is a drawing in which the housing, connector module, and printed circuit board are disassembled and shown in FIG. 8.
FIG. 10 is a exploded view of an electronic device according to the fourth exemplary embodiment of the present invention.
FIG. 11 is a perspective view of the housing according to the fourth exemplary embodiment of the present invention.
FIG. 12 is a perspective view of the connector module according to the fourth exemplary embodiment of the present invention.
FIG. 13 is a drawing showing the grounding structure of the housing and the connector module according to the fourth exemplary embodiment of the present invention.
FIG. 14 is a drawing for explaining the layout structure of the grounding terminal in the housing according to the fourth exemplary embodiment of the present invention.

### [Best Mode]

Hereinafter, exemplary embodiments of the present invention will be described in detail with reference to the accompanying drawings.

However, the present invention is not limited to the given exemplary embodiments described, but may be implemented in a variety of different forms, and one or more of components among the exemplary embodiments may be optionally combined or substituted between embodiments within the scope of the present invention.

Furthermore, terms (including technical and scientific terms) used in the embodiments of the present invention, unless expressly specifically defined and described, are to be interpreted in the sense in which they would be understood by a person of ordinary skill in the art to which the present invention belongs, and commonly used terms, such as dictionary-defined terms, are to be interpreted in light of their contextual meaning in the relevant art.

Furthermore, the terms used in the embodiments of the invention are intended to describe the embodiments and are not intended to limit the invention.

In this specification, the singular may include the plural unless the context otherwise requires, and references to "at least one (or more) of A and (or) B and C" may include one or more of any combination of A, B, and C that may be assembled.

In addition, the terms first, second, A, B, (a), (b), and the like may be used to describe components of embodiments of the invention. Such terms are intended only to distinguish one component from another, and are not intended to limit the nature or sequence or order of such components by such terms.

Furthermore, when a component is described as "connected," "coupled," or "attached" to another component, it can include cases where the component is "connected," "coupled," or "attached" to the other component directly, as well as cases where the component is "connected," "coupled," or "attached" to another component that is between the component and the other component.

Furthermore, when described as being formed or disposed "above" or "below" each component, "above" or "below" includes not only when two components are in direct contact with each other, but also when one or more other components are formed or disposed between the two components. Furthermore, when expressed as "above" or "below", it may include the meaning of upward as well as downward with respect to a single component.

The electronic device according to the first exemplary embodiment is equipped in a vehicle (car) and may include an electronic control unit (ECU) such as a converter, pump, motor, and controller. However, this is an example, and the electronic device may include various devices that include at least one or more electronic components placed in a housing.

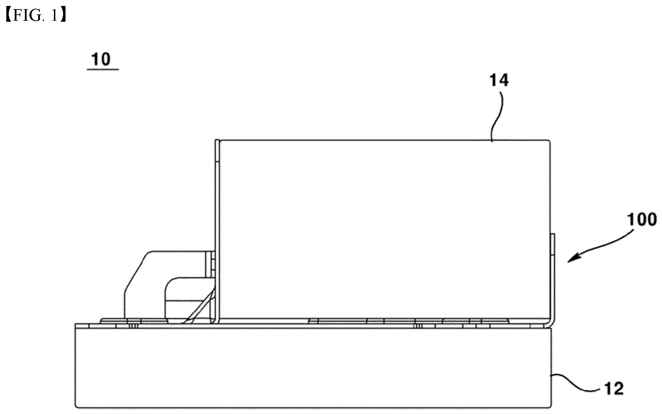

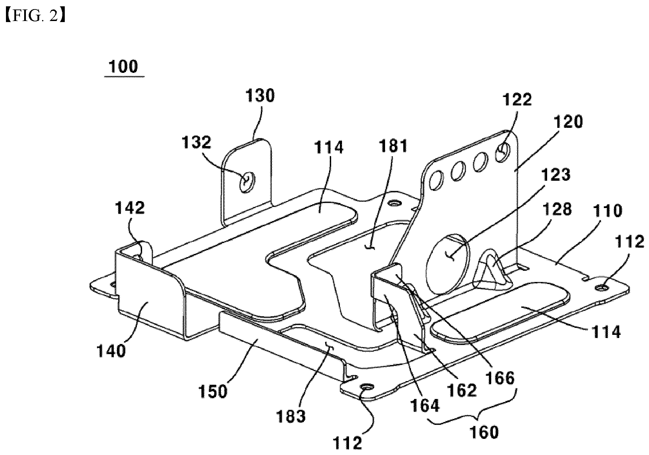

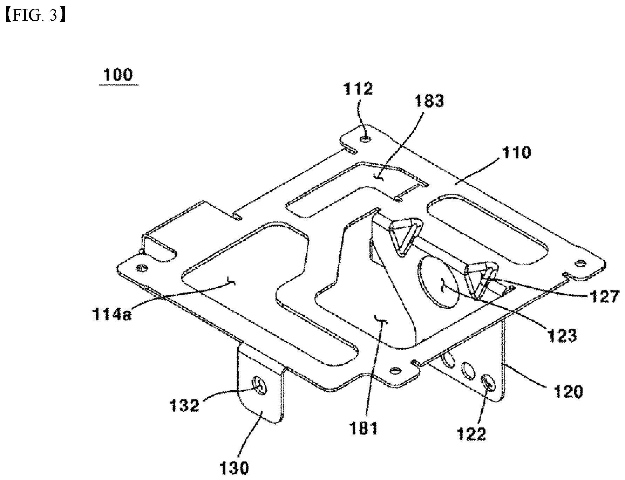

FIG. 1 is a top view of the electronic device according to the first exemplary embodiment of the present invention, and FIG. 2 is a side view of the top surface of the bracket according to the first exemplary embodiment of the present invention, and FIG. 3 is a side view of the bottom surface of the bracket according to the first exemplary embodiment of the present invention.

Referring to FIG. 1, an electronic device (10) according to the first exemplary embodiment of the present invention may be combined with each other through a bracket (100) by multiple modules. The plurality of modules may be disposed in upper and lower portions, respectively, with respect to the bracket (100). The plurality of modules may include a first module (12) disposed on a lower surface of the bracket (100) and a second module disposed on an upper surface of the bracket (100). The first module (12) and the second module (14) may be screwed to the upper and lower surfaces of the bracket (100), respectively.

The above-mentioned first module (12) may include an electronic control unit (ECU). The first module (12) may be connected to a motor and can control the operation of the motor.

The second module (14) may be another electronic device that is electrically connected to the first module (12). The second module (14) may be a control module that controls the first module (12). Alternatively, the second module (14) may be a power module that provides power to the first module (12) and the motor.

The electronic device (10) may be disposed in a vehicle.

As shown in FIGS. 2 and 3, the bracket (100) according to the first embodiment of the present invention may be formed by processing a single metal plate (sheet material). The bracket (100) may include a base (110) and a plurality of support members arranged perpendicularly with respect to the base (110). The base (110), the plurality of support members, and the support coupling (160) parts (described below) may be formed as a single body.

The base (110) may be formed in the shape of a plate. The second module (14) may be disposed on an upper surface of the base (110), and the first module (12) may be disposed on a lower surface of the base (110). The base (110) may have a rectangular cross-sectional shape.

The base (110) may include a first screw hole (112). The first screw hole (112) may be in a shape that penetrates the lower surface from the upper surface of the base (110). A screw may be coupled to the first screw hole (112), and the second module (14) may include a screw hole facing the first screw hole (112). Accordingly, the second module (14) can be screwed to the first screw hole (112) through the screw. The first screw hole (112) may be provided in multiple numbers and may be disposed in a corner area of the base (110) respectively.

The base (110) may include a protrusion (114). The protrusion (114) may be shaped to protrude upward from the upper surface of the base (110) relative to other areas. A recess (114a) may be formed in the area of the base (110) corresponding to the formation area of the protrusion (114) in the lower surface of the base (110). The protrusions (114) may be provided in multiple numbers and may be arranged at a distance from each other. The plurality of protrusions (114) may be arranged facing each other with respect to a first support part (120) to be described later. The strength of the base (110) can be reinforced through the protrusions (114).

The plurality of support parts may have a shape that protrudes upward from the upper surface of the base (110). The multiple support parts may each be disposed perpendicularly with respect to the base (110). The plurality of support parts may be coupled to the side of the second module (140). Alternatively, some of the plurality of support parts may be coupled with the side of the second module (140), and the remaining portion may be coupled with the installation area of the electronic device (10) in the vehicle. The plurality of support parts may be formed by bending a single metal plate with the exception of the forming area of the base (110) with respect to the base (110).

The plural support parts may include the first support part (120), the second support part (130), and the third support part (140). The first support part (120) may be formed by cutting a portion of the single metal plate and bending the cut area with respect to the base (110). The first support part (120) may be disposed approximately in the center of the base (110). The first support part (120) may be disposed perpendicularly to the base (110). The length from the upper surface of the base (110) to the upper end of the first support part (120) may be longer than the length from the upper surface of the base (110) to the upper end of the second support part (130) or the third support portion (140).

The first support part (120) may support the side of the second module (14). The first support part (120) may include a coupling hole penetrating from one surface to the other surface. The coupling hole may include a first coupling hole (123) and a second coupling hole (122). The first coupling hole (123) may be arranged adjacent to the lower end of the first support part (120).

The first coupling hole (123) may have a circular cross-sectional shape. At least a portion of the second module (14) may be coupled to the first coupling hole (123), or a portion of the outer surface of the second module (14) may be exposed to another area through the first coupling hole (123). The second coupling hole (122) may be disposed adjacent to the upper end of the first support part (120).

The first coupling hole (123) may have a circular cross-sectional shape.

A screw may be coupled to the second coupling hole (122), and the second module (14) may be screwed to the first support part (120) through the screw.

As mentioned above, the first support part (120) may be formed by cutting a portion of the metal plate. Accordingly, a first hole (181) of a shape penetrating the lower surface from the upper surface may be formed in the base (110). The first support part (120) may be disposed on the inner perimeter of the first hole (181). The cross-sectional shape of the first hole (181) may be formed to correspond to the cross-sectional shape of the first support part (120). For example, the cross-sectional shape of the first hole (181) and the first support part (120) may be approximately trapezoidal.

The first hole (181) may be disposed perpendicularly to the first support part (120).

A first groove (127) may be formed in an area where one end of the first support part (120) is connected to the inner surface of the first hole (181). Part of the first groove (127) may be formed on one side of the first support (120), and the remaining part may be formed on the lower surface of the base (110). **In** the area where the first groove (127) is formed and corresponds to the area where the first support part (120) and the base (110) are connected, a rib (128) having a shape that protrudes outward may be formed. A portion of the rib (128) may be formed on the other surface of the first support part (120) and the remaining portion may be formed on the upper surface of the base (110).

The strength of the connection area between the first support part (120) and the base (110) can be reinforced through the rib (128). The rib (128) may be provided in multiple numbers and may be disposed at a distance (spaced apart) from each other.

Meanwhile, the connection area of the first support part (120) and the base (110) may be referred to as the bending part, and the first groove (127) may be understood as being formed on the inner surface of the bending part, and the rib (128) may be understood as being formed on the outer surface of the bending part.

The second support part (130) may have a shape that protrudes upward from the edge of the base (110). The second support part (130) may be coupled to the side of the second module (14). The side of the second module (14) that is coupled with the second support part (130) may face the side of the second module (14) that is coupled with the first support part (120). The second support part (130) may be disposed perpendicularly to the base (110). The second support (130) may also be formed by bending a portion of a single metal plate with respect to the base (110). The second support part (130) may include a screw hole (132) for screw connection with the second module (14).

The third support part (140) may have a shape that protrudes upward from the edge of the base (110). The third support part (140) may be coupled to the side of the second module (14). The side of the second module (14) that engages with a fourth support part (140) may be adjacent to the side of the second module (14) that engages with the first support part (120) or the side of the second module (14) that engages with the second support part (130). The third support part (140) may be disposed perpendicularly to the base (110). The third support (140) may also be formed by bending a portion of a single metal plate relative to the base (110). The third support part (140) may include a screw hole (142) for threaded connection with the second module (14). The third support part (140) may have at least one bent area. The third support part (140) may be formed with a cross-sectional shape of approximately an '¬' shape.

The bracket (100) may include an additional support part (150) in addition to the first to third support parts (120, 130, 140), and the additional support part (150) may also be bent upward from the edge of the base (110) and disposed perpendicularly to the base (110). The additional support part (150) can support the side of the second module (14).

The bracket (100) may include a support coupling part (160) that supports the first support part (120). The support coupling part (160) may support one side of the first support (120). The side of the first support portion (120) facing the first hole (181) may be opposite to the side of the first support part (120) with which the support coupling part (160) is coupled.

The support coupling part (160) may be formed by cutting a portion of the metal plate. A second hole (183) that penetrates the lower surface from the upper surface may be formed in the base (110). The support coupling part (160) may be positioned at one end on the inner perimeter of the second hole (183). The cross-sectional shape of the support coupling part (160) may be formed to correspond to the cross-sectional shape of the second hole (183). The second hole (183) and the base (110) may be disposed perpendicularly to the support coupling (160).

The support coupling portion (160) may be connected to the base (110) at one end, and the other end may be coupled to the side of the first support part (120). The other end of the support coupling part (160) may be joined to the side of the first support (120) by welding.

The support coupling part (160) may include a first region (162) extending upward from the upper surface of the base (110), a second region (164) extending in a horizontal direction parallel to the base (110) from the upper end of the first region (162), and a third region (166) that is bent from the extended end of the second region (164) and coupled to the side of the first support part (120). The first area (162) may be disposed perpendicularly to the base (110), the second region (164), and the third region (166). The second region (164) may be disposed perpendicularly to the third region (166). One side of the third region (166) may be welded to one side of the first support part (120).

According to the above structure, the coupled area of multiple modules may be formed through a single metal plate, which has the advantage of reducing the number of parts for forming the bracket, thereby lowering the manufacturing cost, and improving production efficiency by omitting the joining process between multiple plates.

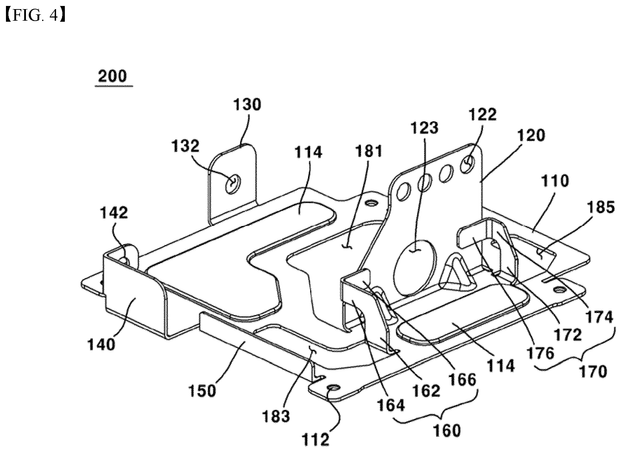

FIG. 4 is a top view of the bracket according to the second embodiment of the present invention.

**In** this embodiment, the other parts are the same as in the first embodiment, except that the support coupling is provided in multiple numbers. Therefore, the same drawing symbols are assigned to the same configuration as in the first embodiment, and only the characteristic parts of this embodiment are explained below, and the rest of the parts are described using the first embodiment.

As shown in FIG. 4, the present embodiment has multiple support couping parts. **In** this case, the support coupling part (160) of the first embodiment described above may be named as the first support coupling part (160), and the other support coupling parts among the plurality of support coupling parts may be named as the second support coupling part (170).

The second support coupling part (170) can support one side of the first support part (120). One side of the first support part (120) can be supported by the first support coupling part (160) and the second support coupling part (170).

The second support coupling part (170) may be formed by cutting a portion of the metal plate. A third hole (185) in the shape of penetrating the lower surface from the upper surface may be formed in the base (110). The second support coupling part (170) may be disposed at one end on the inner perimeter of the third hole (185). The cross-sectional shape of the second support coupling part (170) may be formed to correspond to the cross-sectional shape of the third hole (185). The third hole (185) and the base (110) may be disposed perpendicularly to the second support coupling part (170).

The second support coupling part (170) may be disposed in a horizontal direction to overlap with the first support coupling part (160). Based on the first support part (120), the first support coupling part (160) and the second support coupling part (170) may be arranged symmetrically.

The second support coupling part (170) may be connected to the base (110) at one end and coupled to the side of the first support part (120) at the other end. The other end of the second support coupling part (170) may be joined to the side of the first support part (120) by welding.

The second support coupling part (170) may include a first region (172) extending upward from the upper surface of the base (110), a second region (174) extending in a horizontal direction parallel to the base (110) from the upper end of the first region (172), and a third region (176) bent from the extended end of the second area (174) and coupled to the side of the first support part (120). The first region (172) may be disposed perpendicularly to the base (110), the second region (174), and the third region (176). The second region (174) may be disposed perpendicularly to the third region (176). One side of the third region (176) can be welded to one side of the first support part (120).

In this embodiment, multiple support coupling parts may be formed to support one side of the first support part more firmly than in the first embodiment.

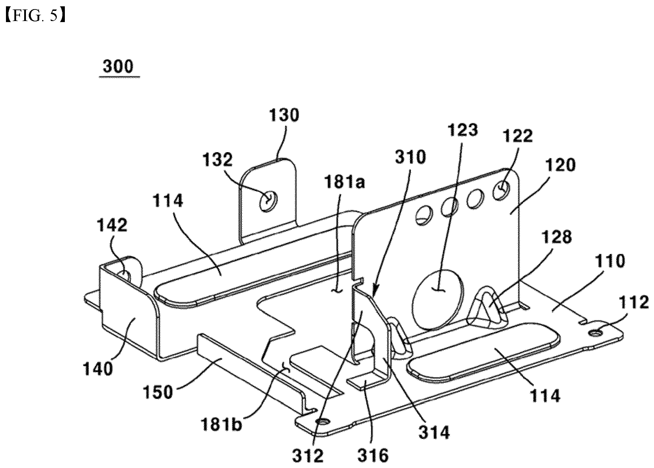

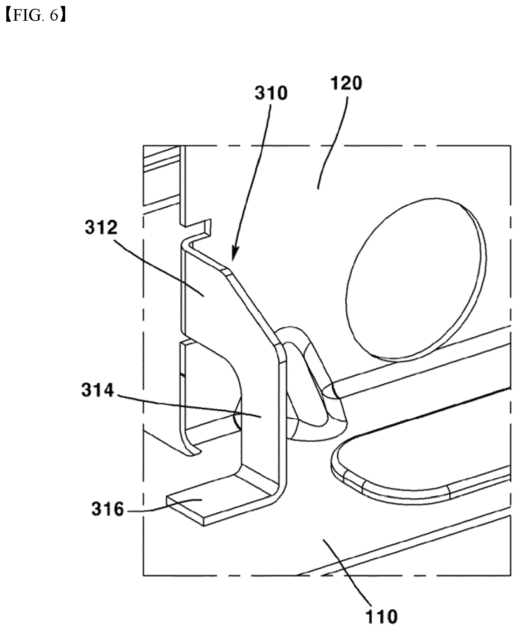

FIG. 5 is a top view of the bracket according to the third exemplary embodiment of the present invention, and Fig. 6 is a magnified view of a portion of FIG. 5.

In this embodiment, the other parts are the same as in the first embodiment, except that the support coupling part extends from the first support part. Therefore, the same drawing symbols are assigned to the same configurations as in the first embodiment, and only the characteristic parts of this embodiment are described below, and the remaining parts are described using the first embodiment.

As shown in FIGS. 5 and 6, in this embodiment, the bracket (300) may include a support coupling part (310). In this case, unlike the first embodiment, the support coupling part (310) may extend outward from the first support part (120) rather than the base (110). Accordingly, the second hole (183, see FIG. 2) may not be formed due to the formation of the support coupling part (160, see FIG. 2) described in the first embodiment.

In addition, the first hole (181a, 181b) formed in the base (110) may also be formed so that its cross-sectional shape corresponds to the sum of the cross-sectional shapes of the support coupling part (310) and the first support part (120). Accordingly, the first hole (181a, 181b) may include a first-1 hole (181a) corresponding to the cross-sectional shape of the first support part (120) and a first-2 hole (181a) corresponding to the cross-sectional shape of the support coupling part (310). The first-1 hole (181a) and the first support part (120) may have a rectangular cross-sectional shape.

The first-1 hole (181a) and the first-2 hole (181b) may be interconnected.

The support coupling part (310) may extend from one end from the edge of the first support part (120) and the other end may be coupled to the upper surface of the base (110). The other end of the support coupling part (310) may be joined to the upper surface of the base (110) by welding.

The support coupling part (310) may include a first region (312) extending from one side of the base (120), a second region (314) connected to the first region (312) at one end and extending downward, and a third region (316) bent from the other end of the second region (314) and coupled to the upper surface of the base (110). The second region (314) may be disposed perpendicularly to the first region (312), the third region (316), and the base (110) and may be disposed parallel to the first support part (120). The lower surface of the third region (316) may be welded to the upper surface of the base (110).

In this embodiment, one side of the first support part (120) may be supported with respect to the base (110) through the support coupling part (310).

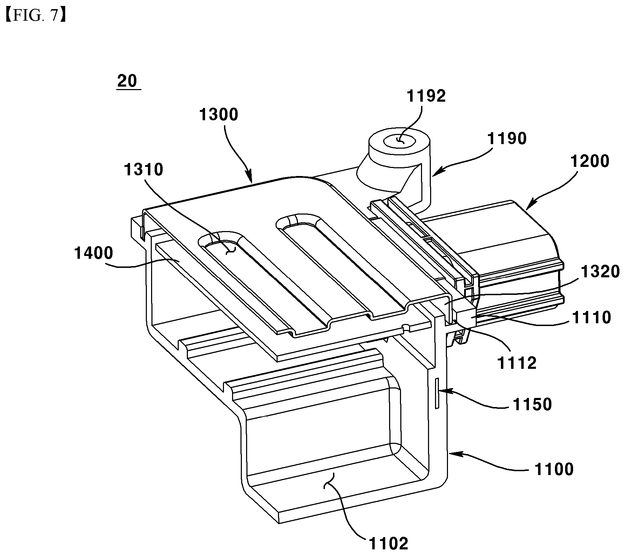

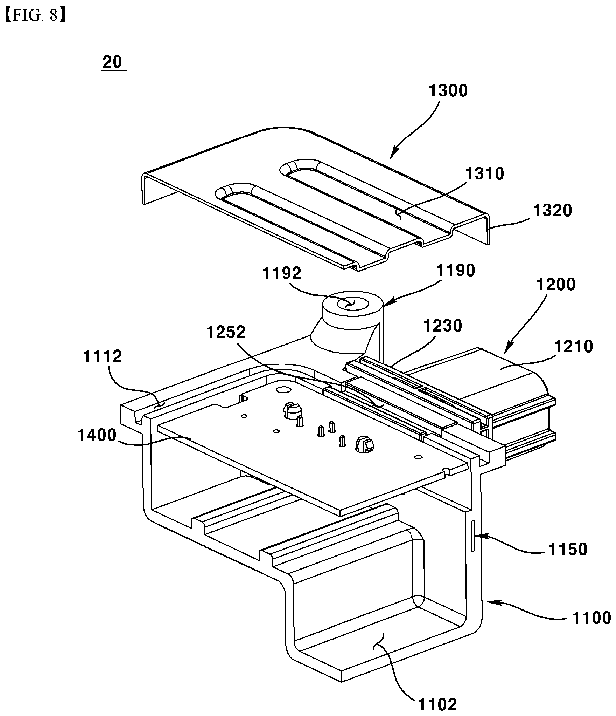

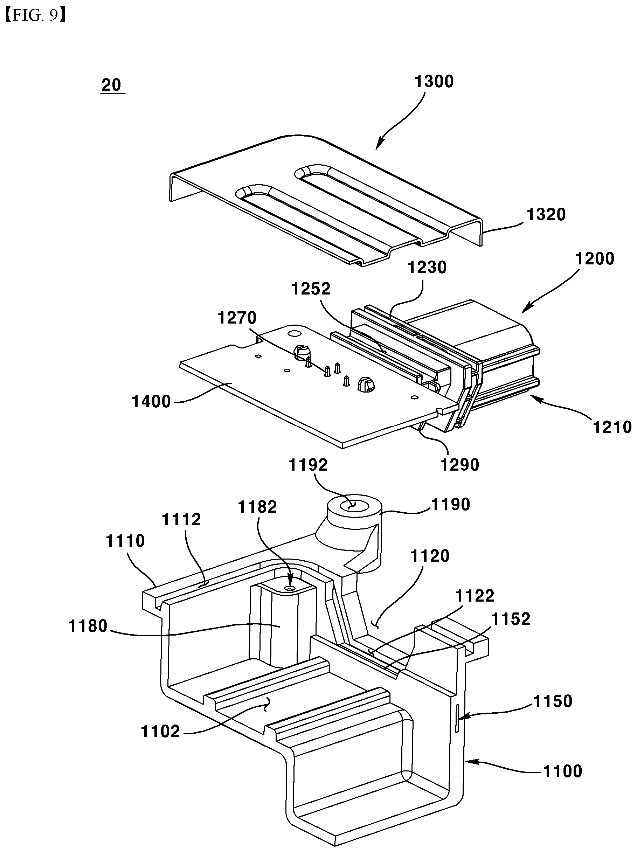

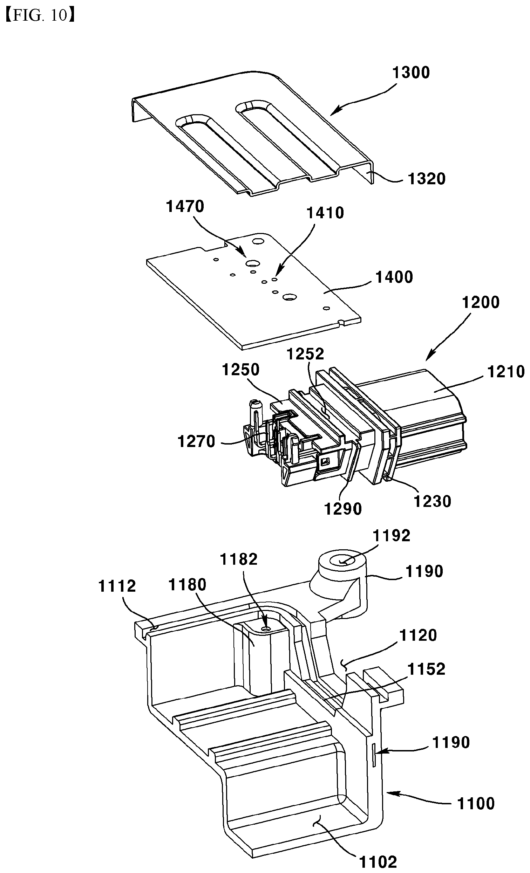

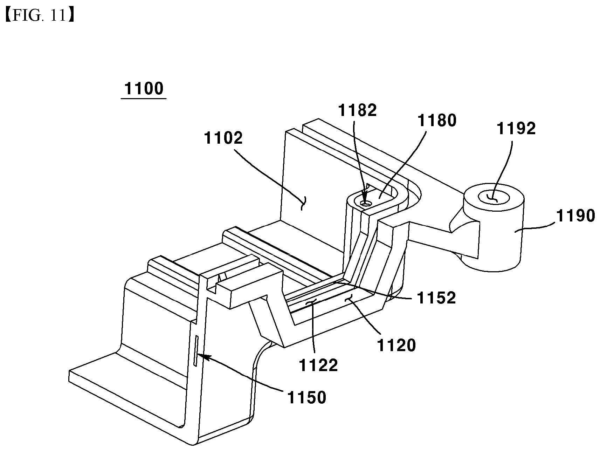

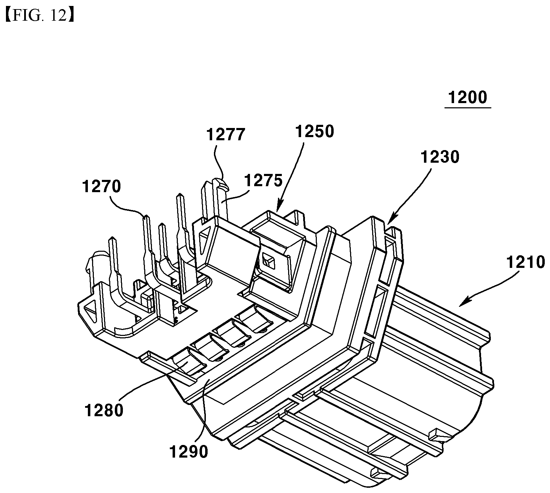

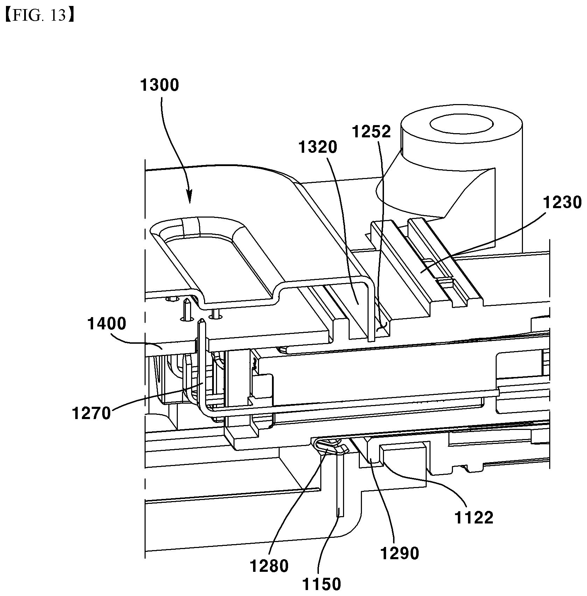

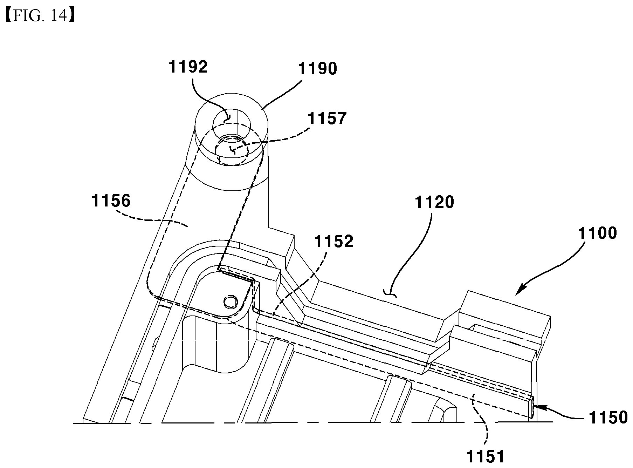

FIG. 7 is a perspective view of the exterior of an electronic device according to a fourth exemplary embodiment of the present invention, FIG. 8 is a drawing in which a housing and a cover are disassembled from FIG. 7, FIG. 9 is a drawing in which the housing, connector module, and printed circuit board are disassembled and shown in FIG. 8, FIG. 10 is a exploded view of an electronic device according to the fourth exemplary embodiment of the present invention, FIG. 11 is a perspective view of the housing according to the fourth exemplary embodiment of the present invention, FIG. 12 is a perspective view of the connector module according to the fourth exemplary embodiment of the present invention, FIG. 13 is a drawing showing the grounding structure of the housing and the connector module according to the fourth exemplary embodiment of the present invention, and FIG. 14 is a drawing for explaining the layout structure of the grounding terminal in the housing according to the fourth exemplary embodiment of the present invention.

An electronic device according to this embodiment is equipped in the vehicle and may include a converter, a pump, and an electronic control unit (ECU). However, this is an example, and the electronic device may include at least one or more electronic components arranged in a housing, and various devices electrically connected via external terminals and connectors.

As shown in FIGS 7 to 14, an electronic device (20) according to this embodiment may include a housing (1100), a connector module (1200), a cover (1300), and a printed circuit board (1400).

The housing (1100) may form the outer shape of the electronic device (20). A space (1102) may be formed inside the housing (1100) for placing at least one or more components for the operation of the electronic device (20). The housing (1100) may be shaped as a box with an upper opening. FIGS. 7 to 10 show a cross-section of the housing (1100) by partially cutting it open to illustrate the grounding structure of the connector module (1200). The cross-section of the housing (1100) may be rectangular.

The housing (1100) may form a lower plate and a side plate that is bent from the edge of the lower plate and extends upward. The lower plate may form the bottom of the electronic device (20). The side plate may form the side of the electronic device (20). The space (1102) may be formed by the upper surface of the lower plate and the inner surface of the side plate.

The upper surface of the lower plate, which is the bottom surface of the space (1102), may include multiple staircase regions of different heights.

A support part (1180) that protrudes upward from the upper surface of the lower plate and supports the lower surface of the printed circuit board (1400) may be formed on the upper surface of the lower plate. A hole (1182) may be formed on the upper surface of the support part (1180) into which a screw (not shown) may be coupled.

A first coupling groove (1112) may be formed on the upper surface of the housing (1100) in a shape that is recessed relative to other areas. The side plate (1320) of the cover (1300) may be coupled to the first coupling groove (1112). The first coupling groove (1112) may be formed along the periphery of the upper surface of the housing (1100).

A hole (1120) may be formed in the housing (1100) for the connector module (1200) to be coupled to. The hole (1120) may be formed to penetrate the inner surface from the outer surface of the housing (1100). The hole (1120) may be formed on the side of the housing (1100). When the housing (1100) is viewed from the top, the hole (1120) may be in the shape of a groove that is stepped downward from other areas. The inner surface of the hole (1120) may be disposed steppedly (staircasedly) at a lower level than the upper surface of the housing (1100). The hole (1120) may be called a connector coupling groove.

A second coupling groove (122) may be formed on the inner surface of the hole (1120) that is recessed relative to other areas. The second coupling groove (1122) may be formed on the bottom surface of the connector coupling groove. The second coupling groove (1122) may be formed on the inner perimeter of the hole (1120).

As shown in FIG. 11, the second coupling groove (1122) may be connected to the first coupling groove (1122). The first coupling groove (1112) and the second coupling groove (1122) may each have a rectangular cross-sectional shape.

A vehicle body coupling part (1190) may be disposed on the exterior of the housing (1100). The vehicle body coupling part (1190) may protrude from the outer surface of the housing (1100). The vehicle body coupling part (1190) may be provided in multiple numbers and may be placed in each corner area of the housing (1100). On the upper surface of the vehicle body coupling part (1190), a first screw hole (1192) may be formed into which a screw (not shown) can be attached. Through the vehicle body coupling part (1190), the electronic device (20) can be attached to a vehicle body that forms the frame of the car, like the chassis. In this case, the screw can be screwed into a vehicle body and the vehicle body coupling part (1190) respectively.

The housing (1100) may be formed of plastic material. Accordingly, the electronic device (20) can be made lightweight when compared to a metal material.

The cover (1300) may be disposed on the upper part of the housing (1100). The cover (1300) may be combined to cover the upper surface of the space (1102). The cover (1300) may include a side plate (1320). The side plate (1320) may be formed by bending downward from the edge of the central region and may form the side of the cover (1300). The lower end of the side plate (1320) may be coupled to the first coupling groove (1112). Some of the lower ends of the side plate (1320) may be coupled to a third coupling groove (1252) of the connector module (1200) to be described later.

On the upper surface of the cover (1300), a groove (1310) may be formed in which the bottom surface is stepped (staircased) downward relative to other areas to increase the cross-sectional area.

A printed circuit board (1400) may be disposed in the space (1102) within the housing (1100). The printed circuit board (1400) may be formed in a plate shape, and at least one of the surfaces of the upper or lower surface may be provided with at least one electronic component for driving the electronic device (20). The printed circuit board (1400) may be coupled with the pins (1270) of the connector module (1200) described below. The printed circuit board (1400) may include a pinhole (1410) for a pin (1270) to be coupled to, and the pin (1270) may be mounted in the pinhole (1410).

The lower surface of the printed circuit board (1400) may be contacted with the upper surface of a support part (1180). The upper surface of the support part (1180) may support the lower surface of the printed circuit board (1400). The printed circuit board (1400) may include a hole facing the hole (1182) formed on the support part (1180), and the screw may be threaded through the hole of the printed circuit board (1400) and screwed into the hole (1182) of the support part (1180).

The lower surface of the printed circuit board (1400) may be in contact with at least a portion of the upper surface of a second region (1250) of the connector module (1200).

The connector module (1200) may be disposed to penetrate the side of the housing (1100). The connector module (1200) may be disposed to penetrate the hole (1120). The connector module (1200) may be coupled to the hole (1120). The connector module (1200) may be placed in a connector coupling groove.

The connector module (1200) may be coupled with an external terminal, thereby providing power to the electronic device (20) or transmitting and receiving control signals related to the operation of the electronic device (20).

The connector module (1200) may include one end that is disposed in a space (1102) within the housing (1100) and the other end that is disposed on the outside of the housing (1100).

As shown in FIG. 12, the connector module (1200) may be shaped by a connector housing. The material of the connector housing may be plastic. A pin (1270) may be disposed at one end of the connector housing, which is placed in the space (1102) within the housing (1100). The pin (1270) protruding from one end of the connector housing may have an area that is bent at least once to be coupled with the printed circuit board (1400).

In detail, the connector module (1200) may include a first region (1210), a second region (1250), and a guide (1230).

The first region (1210) may be placed on the outside of the housing (1100). An external terminal may be coupled to the first region (1210). Accordingly, the first region (1210) may be named as a connector withdrawal part. The first region (1210) may have a shape that protrudes outward from the housing (1100).

The second region (1250) may be disposed within the housing (1100). At least a portion of the second region (1250) may be coupled to the hole (1120). The end of the second region (1250) may be provided with a pin (1270). The pin (1270) may be disposed along the space within the first region (1210), the guide (1230) and the second area (1250), and one end may be coupled to the external terminal and the other end is coupled to the printed circuit board (1400). This allows the electronic device (20) and the external terminal to be electrically connected.

In the region of the upper surface of the above-mentioned second region (1250) that overlaps with the printed circuit board (1400) in the vertical direction, ribs (1275, see FIG. 12) that protrude upward more than in other areas may be formed. The ribs (1275) may be provided in multiple numbers and may be arranged on both sides of the pins (1270). The printed circuit board (1400) may include a coupling hole (1470) so that the ribs (1275) can be coupled. This allows the connector module (1200) and the printed circuit board (1400) to be more firmly connected. The ribs (1275) pass through the coupling hole (1470) so that at least a portion of it can be placed on the top of the printed circuit board (1400). An upper end (1277) of the rib (1275) disposed on the top of the printed circuit board (1400) may be formed with a larger cross-sectional area than other areas.

A third coupling groove (1252) may be formed on the upper surface of the second region (1250) to be recessed relative to the other regions. The third coupling groove (1252) may be arranged to overlap the side plate of the housing (1100). The third coupling groove (1252) may be connected to the first coupling groove (1112). The third coupling groove (1252) may be arranged to correspond to the hole (1120) formation area. Therefore, when the cover (1300) is coupled to the housing (1100), some of the lower end of the cover (1300) may be coupled to the first coupling groove (1112), and the remaining portion may be coupled to the third coupling groove (1252).

On the lower surface of the second region (1250), there may be disposed a protrusion (1290) that protrudes more downward than the other region. The protrusion (1290) may be coupled to the second coupling groove (1122). The cross-sectional shape of the protrusion (1290) may be formed to correspond to the cross-sectional shape of the second coupling groove (1122). The protrusion (1290) may be coupled to the inner surface of the hole (1120).

The guide (1230) may be interposed between the first region (1210) and the second region (1250). The guide (1230) may be formed with a larger cross-sectional area than the first region (1210) and the second region (1250). The guide (1230) may be coupled to the side of the housing (1100). The inner surface of the guide (1230) may be in contact with the outer surface of the housing (1100). As shown in FIG. 11, the side of the housing (1100) on which the guide (1230) is in contact may protrude outward more than other regions.

The connector module (1200) may include a grounding pin (1280). The grounding pin (1280) may be disposed in the connector housing. The grounding pin (1280) may be disposed so that it protrudes outward from the lower surface of the second region (1250). One end of the grounding pin (1280) has a bent area at least once, and the cross-section may be formed into an approximately 'U' shape. The grounding pins (1280) may be provided in multiple numbers and may be disposed at a distance (spaced apart) from each other. The grounding pin (1280) may have a ground power source.

A grounding terminal (1150) may be disposed in a region of the inner surface of the hole (1120) that faces a battery pin (1280). At least a portion of the grounding terminal (1150) may protrude from the inner surface of the hole (1120) and contact the grounding pin (1280).

The area of the grounding terminal protruding from the inner surface of the hole (1120) may be named a contact area (1152).

The grounding terminal (1150) may be made of metal and may have a ground power supply. By combining the grounding terminal (1150) and the grounding pin (1180), an electric shock accident caused by a short circuit can be prevented in the area where multiple terminals are electrically connected, and a reference potential with zero potential may be set.

The grounding terminal (1150) may be integrally formed with the plastic housing (1100) by insert injection.

In detail, the above grounding terminal (1150) may include a plurality of regions that are arranged perpendicularly to each other. For example, as shown in FIG. 14, the grounding terminal (1150) may include a first terminal region (1151) in which the contact region (1152) is formed, and a second terminal region (1156) that is disposed perpendicularly to the first terminal region (1151) and that is at least partially accommodated within the vehicle body coupling part (1190). The first terminal region (1151) and the second terminal region (1156) may be formed as one body.

The first terminal region (1151) may be disposed within one side of the housing (1100), and the second terminal area (1156) may be disposed at least in part within at least one side of the housing (1100) that is adjacent to at least one other side.

The first terminal region (1151) may be disposed within the side plate of the housing (1100).

The first terminal area (1151) may be interposed between the inner and outer surfaces of the housing (1100) side plate, and at least a portion of it may be disposed so that it protrudes from the inner surface of the hole (1120) through the contact area (1152).

At least a portion of the second terminal region (1156) may be disposed within the vehicle body coupling part (1190). A distal end of the second terminal area (1156) may include a second screw hole (1157) that is disposed to overlap the first screw hole (1192) of the vehicle body coupling part (1190). Therefore, when the screws are screwed into the first screw hole (1192) and the second screw hole (1157), the grounding terminal (1150) may be electrically connected to the vehicle body. Accordingly, a grounding structure leading from the connector module (1200) to the vehicle body can be implemented.

According to the above structure, the grounding terminal is integrally formed in the plastic housing, which has the advantage of being lightweight and easily implementing the grounding structure of the connector module.

In addition, the grounding structure that is connected with the assembly of the housing and the connector module has the advantage of improving assembly and production efficiency.

In the above, it is not necessarily limited to this embodiment, even though all components constituting the embodiment of the present invention are described as being combined or operated by combining them into one. In other words, within the scope of the present invention, all of its components may be selectively combined and operated in one or more. In addition, the terms 'include,' 'comprise,' or 'have,' as used herein, unless specifically stated to the contrary, are intended to mean that the component may be inherent, and should be interpreted to include other components rather than exclude other components. All terms, including technical or scientific terms, have the same meaning as generally understood by a person with ordinary skill in the art to which the invention belongs, unless otherwise defined. Terms that are commonly used, such as those defined in dictionaries, should be interpreted in a manner consistent with their contextual meaning in the relevant art, and should not be interpreted in an idealized or overly formal sense unless explicitly defined in the present invention.

The above description is merely an illustrative example of the technical idea of the present invention, and a person with ordinary knowledge in the technical field to which the present invention belongs will be able to make various modifications and variations within the scope that does not deviate from the essential characteristics of the present invention. Therefore, the exemplary embodiments disclosed in the present invention are not intended to limit the technical idea of the present invention, but to explain it, and the scope of the technical idea of the present invention is not limited by these embodiments. The scope of protection of the present invention should be interpreted by the following claims, and all technical ideas within the scope of the equivalent thereof should be interpreted as being included in the scope of protection of the present invention.

## Claims

1. A bracket comprising:
a base, and
a first support part having a shape protruding upwardly with respect to the base,
wherein the base comprises a first hole penetrating from an upper surface to a bottom surface thereof, and the first support part is connected to an inner perimeter of the first hole.

2. The bracket of claim 1, wherein a cross-sectional shape of the first support part corresponds to a cross-sectional shape of the first hole.

3. The bracket of claim 1, wherein the base and the first support part are formed as one body.

4. The bracket of claim 1, wherein the first support part includes a first side surface facing the first hole and a second side surface opposite to the first side surface, and includes a support coupling part wherein one end is in contact with the base and the other end is in contact with the first support part.

5. The bracket of claim 4, wherein the base includes a second hole in which an inner perimeter is connected to one end of the support coupling part, and a cross-sectional shape of the second hole corresponds to a cross-sectional shape of the support coupling part.

6. The bracket of claim 4, wherein the support coupling part is welded to one side of the first support part.

7. The bracket of claim 4, wherein the support coupling part is welded to the upper surface of the base.

8. The bracket of claim 4, wherein the support coupling part is provided in multiple numbers, and the base is formed with a plurality of holes each having a shape corresponding to a cross-sectional shape of the multiple support coupling parts.

9. The bracket of claim 4, wherein the support coupling part is bent at least once and include multiple regions that are disposed perpendicularly to each other.

10. An electronic device, the device, comprising:
a bracket;
a first module disposed on one surface of the bracket; and
a second module disposed on the other surface of the bracket,
wherein the bracket includes:
a base disposed between the first module and the second module; and
a first support part having a shape that protrudes upward with respect to the base and supporting a side of the second module,
wherein the base includes a first hole penetrating a lower surface from an upper surface, and the first support part is connected to an inner perimeter of the first hole.
